# EUROPEAN PATENT APPLICATION

(11) **EP 4 300 823 A1**
(43) Date of publication of application: **03.01.2024**
(21) Application number: 22181920.4
(22) Date of filing: 29.06.2022
(51) Int. Cl.: H03H 3/02, H03H 9/17, H01L 21/02

(54) **A LAYER FOR AN ACOUSTIC DEVICE AND A METHOD FOR DEPOSITING THE SAME**

(71) Applicant: Silicon Austria Labs GmbH, 8010 Graz (AT)
(72) Inventor: BRUCKNER, Gudrun, 9241 Wernberg (AT); SCHMID, Ulrich, 1140 Wien (AT); BERGER, Claudio, 2571 Altenmarkt/Triesting (AT); PFUSTERSCHMIED, Georg, 1050 Wien (AT)
(74) Representative: Wirnsberger & Lerchbaum Patentanwälte OG

(57) **Abstract**

The invention concerns a layer for an acoustic device, in particular for a micro acoustic radio frequency device. According to the invention, the layer has essentially a composition SiOₓC_{y}N_{z}, wherein x, y and z > 0.

Furthermore, the invention concerns a method for depositing such a layer.

## Description

The invention concerns a layer for an acoustic device, in particular for a micro acoustic radio frequency device.

Furthermore, the invention comprises a method for depositing a layer consisting essentially of SiOₓC_{y}N_{z}, wherein x, y and z > 0, the layer being designed for a micro acoustic element.

In communication devices like cellular phones, micro acoustic devices like bulk acoustic wave (BAW) resonators are frequently used. A BAW resonator enables coupling of an electrical signal to an acoustic wave in a transversal direction. BAW resonators usually consist of a thin piezoelectric film sandwiched between two electrodes. Typical thin film materials for BAW resonators are aluminum nitride (AIN) or scandium aluminum nitride (ScAIN). The electrodes usually consist of a metal like molybdenum or platinum.

In order to satisfy high quality demands in BAW resonators, a possible loss of acoustic energy should be avoided as far as possible. In this respect, two different concepts are currently used. In the first concept, acoustic energy is confined to a large degree within the sandwiched layer structure by integrating a cavity below the active region. This configuration is known as film bulk acoustic resonator (FBAR) technology. In the second concept, a Bragg mirror is positioned beneath the active region of the sandwiched layer structure. In this latter case, the Bragg mirror is an acoustic mirror and solidly mounted under the active region. For this reason, such a configuration is known as solidly mounted resonator (SMR).

In an SMR configuration, the Bragg mirror consists of a stack of alternating thin layers or films having, on the one hand, a low acoustic impedance (for example silicon dioxide, SiO₂) and, on the other hand, a high acoustic impedance (for example tungsten). The individual layers of low and high acoustic impedance have thicknesses optimized for the overall performance of the device. Preferably, the layer thicknesses are in a range of about a quarter of a wavelength in the respective material so that the acoustic energy can be reflected and confined within the actuating stack.

In order to optimize the performance of a Bragg mirror, a large ratio between the high and low acoustic impedance values of the used materials is of great importance and a first target. The higher the difference between the impedances, the better the reflectivity. Hence, one aim when designing such a Bragg mirror for an SMR configuration is to maximize the ratio between the low and high acoustic impedance values and, therefore, in turn optimize the material properties in corresponding regions.

Besides a desired high reflectivity, a minimization of potential losses is an important second target. This additionally defines a need for tailored material systems for the individual layers of a Bragg mirror.

As in a typical Bragg mirror the high acoustic impedance value material is a metal, for example tungsten or titanium. When the metal component selection is fixed, an increased ratio of the acoustic impedance between alternating layers can only be achieved by using suited materials between the metallic layers. Consequently, a material tuning for such configurations is focused on the development of high-performance layers between the metallic layers of a Bragg mirror.

In this respect, SiO₂ is well-known standard as a low acoustic impedance material used for layers of a Bragg mirror between the metallic layers. Efforts have been made to replace SiO₂ as low acoustic material by similar, but porous and/or low-density materials. These efforts have been made by using silicon oxide carbide (SiOC), carbon-doped oxides (CDO) or organosilicate glass (OSG). With such materials, low specific acoustic impedance values of about 2 to 11 MRayI_{MKS} can be reached (here and in the following, unless otherwise noted, any values in MRayl units refer to MRayl values in the MKS, respectively SI system). However, as a general rule, reducing the density and the stiffness of the material of the layer between metallic layers not only results in a very low acoustic impedance, but also causes increased viscous losses. In Bragg mirrors with such porous and/or low-density materials a much higher acoustic attenuation is given around 300 dB/cm to 5000 dB/cm, even at 1 GHz (T. Jamneala et al., "Ultra-miniature coupled resonator filter with single-layer acoustic coupler", IEEE Trans. Ultrason. Ferroelectr. Freq. Control, 56 (2009), 11, 2553; doi: 10.1109/TUFFC.2009.1342). This is very high when directly compared to the attenuation in SiO₂ of 25 dB/cm. It goes without saying that this reduces the overall quality factor of a device. The quality factor (Q-factor) is a dimensionless parameter describing how damped a resonator is. It is defined as the ratio of the energy stored in the resonator to the energy lost by the resonator per cycle of oscillation. In current state-of-the-art, it is assumed that a low-density structure on the one hand leads to a desired higher difference in the impedance values of the individual layers, but on the other hand introduces a layer with less mechanical stability and especially a decreased elastic modulus. This, in turn leads to increased viscous losses (S. R. Gilbert et al., "Improved coupled resonator filter performance using a carbon-doped oxide decoupling layer", in 2009 IEEE International Ultrasonics Symposium, 2009, 867; doi: 10.1109/ULTSYM.2009.5441848).

It is an object of the invention to address this conflict of targets and to provide a layer for an acoustic device which shows favorable properties as regards high reflectivity as well as a low acoustic loss.

In a further aspect, the invention sets out to provide a method for depositing such a layer.

In one aspect, the invention provides a layer for an acoustic device, in particular for a micro acoustic radio frequency device, wherein the layer has essentially a composition SiOₓC_{y}N_{z}, wherein x, y and z > 0. The layer is designed for an application in a frequency range of 1 GHz to about 100 GHz.

One advantage of a layer according to the invention is that the layer addresses both aims of a high reflectivity on the one hand and low acoustic loss on the other hand. As a working theory, it is assumed that both aims can be achieved by a suited combination of the material composition of the layer and a suited deposition method. According to the invention, nitrogen is used as a further element in comparison with known SiOC layers. This leads besides of Si-O and Si-C bonds also to Si-N bonds. It is believed that a significant amount of bonds of the type Si-C and Si-N leads to more stiffness and, in general, higher mechanical stability within the deposited layer although the same has low density due to the employed plasma enhanced chemical vapor deposition. Hence, even if the layer has low density and is, eventually, also at least partially porous, the losses can be minimized. On the other hand, due to the low density of the layer, the reflectivity can be adjusted to be high. Hence, by tuning the chemical composition and simultaneously using a suited deposition process for the layer, like a plasma enhanced chemical vapor deposition (PECVD), an optimized layer can be obtained.

An inventive layer can be viewed as a thin film. Both expressions may be used synonymously in connection with an inventive layer. Usually, the layer is deposited as a plain thin film which essentially completely covers a below structure.

Although generally any suited deposition process may be employed, a plasma enhanced chemical vapor deposition method may be employed advantageously. Preferably, an inductively coupled plasma (ICP) and a corresponding geometry is used for deposition of the layer.

In a layer according to the invention, Si-H bonds are usually present due to the presence of hydrogen stemming from precursor molecules like silanes or hydrocarbons. Usually, the amount of Si-H bonds is restricted to a minor amount of available binding sides, usually lower than 1% of the available Si binding sites. However, some Si-H bonds are be present due to presence of hydrogen stemming from precursor molecules like silanes or hydrocarbons. The SiOₓC_{y}N_{z} layer can be qualified as a hydrogenated layer.

The layer according to the invention is essentially completely amorphous.

The layer according to the invention may have a desired low density. As a rule, the density is much lower than the density of SiO₂ used as a standard layer. For the latter the mass density is 2.2 g/cm³. In contrast, the density of layer according to the invention is below 1.95 g/cm³. Preferably, the density of an inventive layer is below 1.85 g/cm³. A typical layer density range which is favorable for most applications lies in the range of 1.60 g/cm³ to 1.750 g/cm³.

A layer according to the invention can have a porous structure. The porous structure can include a closed cell pore structure. The layer may be at least partially porous.

As regards the composition, besides the mentioned elements silicon, oxygen, carbon and nitrogen, also some hydrogen may be present however, only in minor amounts. Generally, the layer comprises or essentially consists of (in percent of weight, wt.-%)
20% to 45%, preferably 25% to 40%, in particular 25% to 35%, silicon
40% to 60%, preferably 45% to 57.5%, in particular 47.5% to 55%, oxygen
3% to 25%, preferably 5% to 20%, in particular 7.5% to 15%, carbon
0.5% to 10%, preferably 1.0% to 7.5%, in particular 3.0% to 5.0% nitrogen.

Within the given compositional ranges, an optimum may be achieved for the reflectivity as well as a minimum of losses. Using, besides other precursor molecules, a nitrogen source during the deposition leads to a significant amount of Si-N bonds within the deposited layer. Si-N bonds contribute together with Si-C bonds to a high mechanical stiffness of the deposited layer and, hence, also to a minimization of losses. Despite that, the layer may still have a very low density, thus enabling a high reflectivity. This demonstrates the concept of the invention to provide a low density, high stiffness layer for addressing both technical objectives.

The layer has usually a thickness of less than 1000 nm, preferably 20 nm to 900 nm, in particular 500 nm to 800 nm.

An acoustic impedance of the layer is usually in a range of 6.0 MRayl to 8.0 MRayl. This is much lower than the acoustic impedance of an SiO₂ layer which is typically about 13 MRayl.

According to the foregoing, the invention provides in a further aspect a stack of alternating layers, the layers being deposited by vapor deposition, in particular chemical vapor deposition, wherein the alternating layers comprise a layer according to the invention. In particular, the stack may comprise a sequence of layers A-B, wherein layers A being layers according to the invention and outlined above and layers B are metallic layers. Tungsten layers are well-suited metallic layers for this purpose.

Accordingly, in a further aspect of the invention a Bragg mirror comprises one or more layers according to the invention and/or a stack as outlined above.

In a further aspect, a micro acoustic element comprises such a Bragg mirror.

The invention further provides a method for depositing a layer consisting essentially of SiOₓC_{y}N_{z}, wherein x, y and z > 0, the layer being for a micro acoustic element, the method comprising:
providing a substrate for the deposition of the layer;
depositing the layer by plasma enhanced chemical vapor deposition at a pressure of less than 30 mTorr, wherein at least one precursor molecule is provided for each of silicon, carbon and nitrogen, wherein the substrate is cooled during deposition.

An advantage of a corresponding method is the possibility to provide a thin SiOₓC_{y}N_{z} layer which is extremely useful for micro acoustic elements, for example a Bragg mirror or, generally a stack of layers for providing reflectivity with low losses. The method is in particular useful for providing a layer according to the invention as outlined above.

The method leads to a combination of favorable effects. The plasma enhanced chemical vapor deposition allows to produce a low-density layer for stacks with alternating metallic layers and, hence, a high reflectivity of the stack. This in particular holds when an ICP technology is employed for a plasma generation for a plasma enhanced chemical vapor deposition process. The use of a nitrogen source in turn allows to chemically design a layer having not only Si-C, but also Si-N bonds within the layer. This ensures, despite the low density, high stiffness and in the following low acoustic losses.

The relatively high pressure of up to 30 mTorr together with a cooling of the substrate allows for depositing low-energy plasma ions forming a homogenous low packing density layer. The density and elastic modulus of the material can therefore be tuned in a certain range to fit the requirements of an application. For example, the layer may have a mechanical stiffness in the range of SiO₂ or slightly below but shows a decreased mass density as low as 1.60 g/cm³. Hence, a lower acoustic impedance of around 10 MRayl is reached. In combination with tungsten as high impedance material, this will raise the ratio of high to low impedance materials to 10:1 without causing enhanced acoustic losses as it is observed for a state-off-the-art alternatives to the typical employed low impedance material SiO₂.

The pressure during deposition is preferably in the range of 3 mTorr to 25 mTorr, in particular in the range of 6 mTorr to 20 mTorr. The deposition temperature is preferably kept below 50°C, in particular below 25°C. This refers to the substrate which is cooled during deposition. The substrate itself may be covered by thin films or layers deposited in deposition steps carried out before.

Generally, the suitable precursor molecules for depositing a SiOₓC_{y}N_{z} layer by plasma enhanced chemical vapor deposition are known to a person skilled in the art. At least one silane component, at least one hydrocarbon component and at least one nitrogen source are used within the scope of the invention. For example, SiH₄ is a suitable silicon precursor, methane CH₄ a suitable hydrocarbon component and nitrous oxide N₂O a suitable nitrogen source.

Of course, a couple of layers can be deposited in order to create a stack of layers, in particular layers of a sequence A-B, wherein layers A are layers according to the invention and layers B are metallic layers, for example tungsten layers.

In the following, the invention is discussed in more detail with reference to the drawings.
Fig. 1 shows an example of a BAW resonator stack with SiOₓC_{y}N_{z} as a low acoustic impedance material;
Fig. 2 shows a diagram with data of an X-ray reflectometry of an inventive layer;
Fig. 3 shows measurement results as regards sound velocity measurements of an inventive layer;
Fig. 4 shows an x-ray photoelectron spectrum of an inventive layer;
Fig. 5 shows an impedance spectrum of a BAW device with an inventive layer;
Fig. 6 shows a transmission electron microscope image of an inventive layer;
Fig. 7 shows a diagram showing results of a nanoidentation measurement.

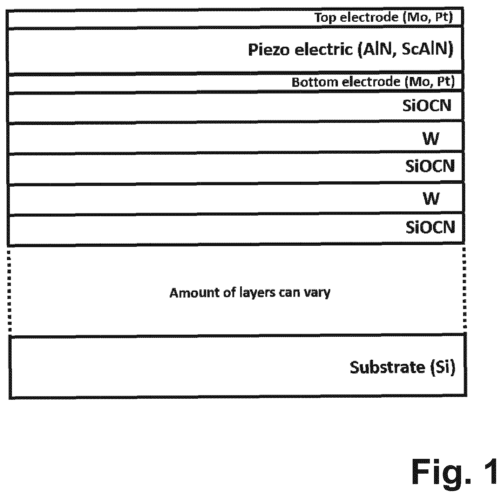

In Fig. 1 an example of a BAW resonator stack with SiOₓC_{y}N_{z} as a low acoustic impedance material. Generally, a sequence of layers A and layers B is given, wherein layers A are SiOₓC_{y}N_{z} layers and layers B are metallic layers, in particular tungsten layers. The stack of alternating layers A and layers B is deposited by plasma enhanced inductively coupled chemical vapor deposition, namely IC-PECVD.

The SiOₓC_{y}N_{z} low acoustic impedance material is deposited in such a way that a low density in the layer or thin film, respectively, is achieved. This, in turn, is accomplished by tailoring process parameters for the layer deposition. Basically, the process parameters for layer deposition are tailored in order to reduce the ion energies of the decomposed precursor compounds. One key feature of the deposition is a relatively low deposition temperature which can be provided using a steady glow discharge as the main energy source for precursor decomposition. Using an ICP is well suited for such purposes. Another feature of the low-density layer deposition is cooling the substrate during deposition.

When an ICP source is used, the same accelerates the species in the plasma onto circular paths rather than perpendicularly onto the substrate. With relatively high chamber pressures and an active cooling of the substrate surface, particle energies are kept relatively low during the process. The reactive precursor gases are delivered in a specific concentration or in a range around these values: 30 % silane (SiH₄), 20 % nitrous oxide (N₂O) and 50 % methane (CH₄). To maintain a stable plasma also an amount of nonreactive argon (Ar) is required, which is the double of the total reactive precursor gas flow. Typical deposition parameters for an Oxford Instruments PlasmaLab 100 ICP-CVD system are given in Table 1 below.

**Table 1: Typical deposition parameters**

| **parameter** | **value** | **range** |
|---|---|---|
| IC plasma power | 500 W | 300 - 1000 W |
| chamber pressure | 9 mTorr | 6 - 20 mTorr |
| substrate temperature | 25°C | 0 - 50°C |

In the following, properties of layers deposited as described in the foregoing and using adjusting parameters as given in table 1 are discussed.

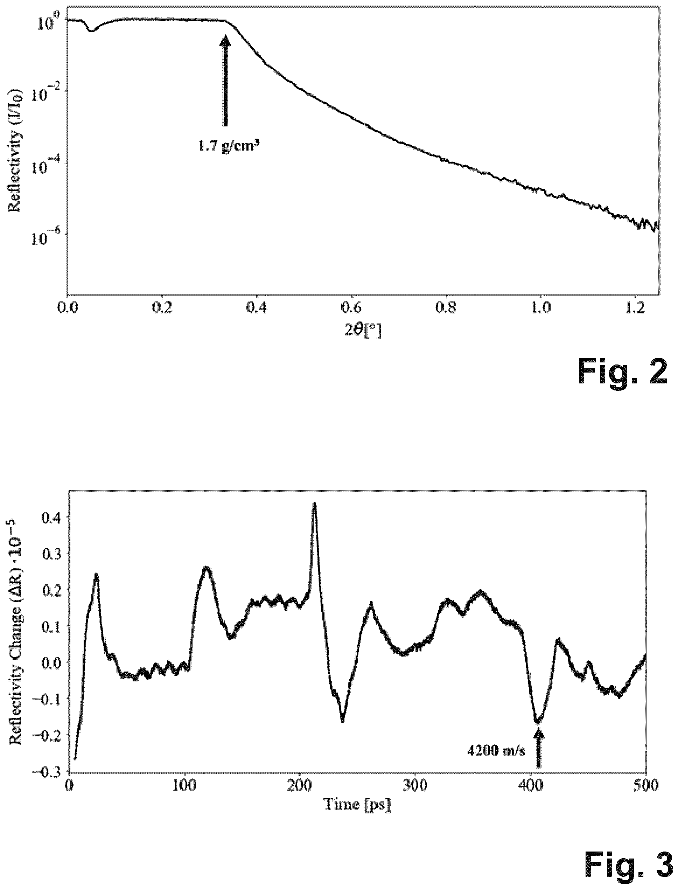

Fig. 2 shows a diagram depicting measurement data of an X-ray reflectometry of an inventive layer. X-ray reflectometry is used for determination of a density of deposited layers, showing the density being in the rage of 1.60 g/cm³ to 1.75 g/cm³. This is in accordance with data obtained by wafer mass weighing before and after deposition of a layer.

Fig. 3 shows a sound velocity measurement by laser probing on an inventive layer with a layer thickness of 720 nm on a silicon wafer, realizing a BAW structure according to Fig. 1. By this technique, sound velocities in the range of 4000 m/s to 4400 m/s have been obtained for different variations of the inventive layer. From this data, one can derive the acoustic impedance, which ranges from 6 MRayl to 8 MRayl for different variations of the inventive layer.

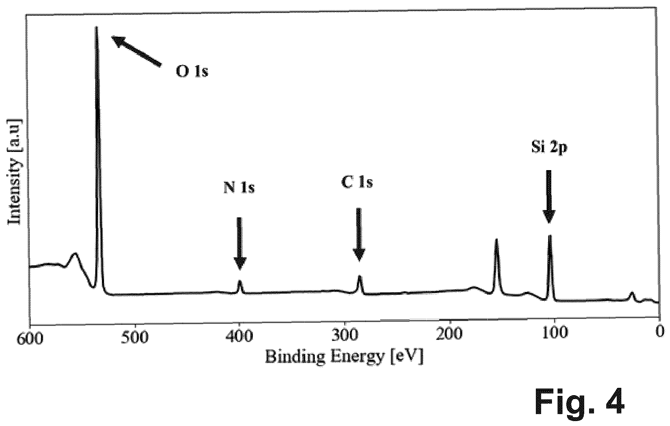

The chemical composition can be determined by X-ray photoelectron spectroscopy (XPS). A typical spectrum is shown in Fig. 4. From the measurement, the composition can be derived. An example is given in Table 2.

**Table 2: Typical chemical compositions of SiOCN thin films**

| **element** | **content [%]** | **general range [%]** |
|---|---|---|
| Silicon (Si) | 32.1 | 25 - 40 % |
| Oxygen (O) | 52.5 | 45 - 60 % |
| Carbon (C) | 11.3 | 5 - 20 % |
| Nitrogen (N) | 4.1 | 1 - 10 % |

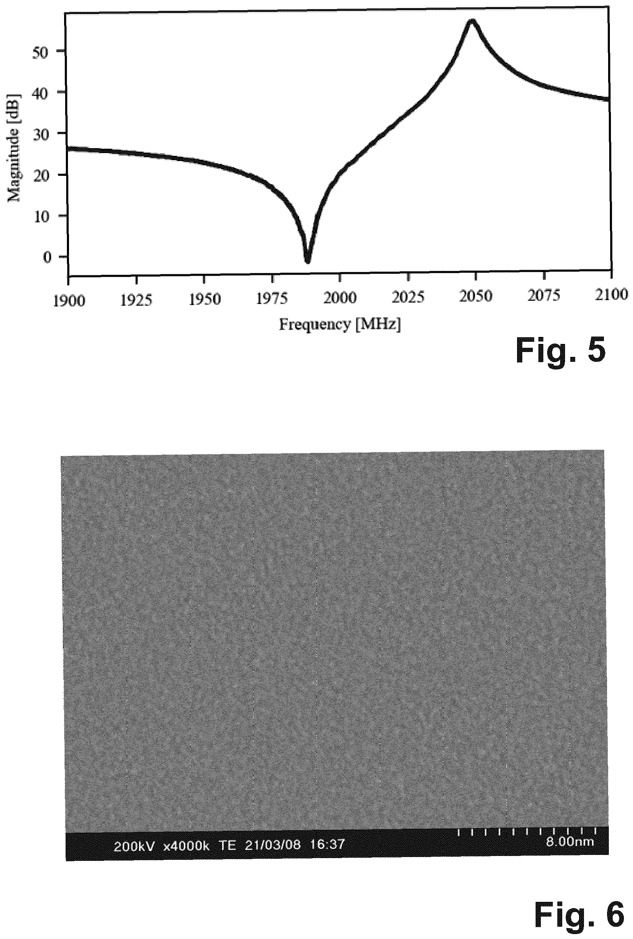

The realization of a SiOCN thin film in an acoustic mirror stack is seen through the impedance spectrum in Fig. 5. Even without optimization, already a desired enhancement in the effective coupling coefficient was seen, which correlates to the bandwidth between resonance and anti-resonance. For the corresponding measurement, thin films of SiOₓC_{y}N_{z} were deposited in snippets with a size of 2 cm² diced from silicon wafers with a BAW stack according to Fig. 1 up to the uppermost layer of tungsten (W). Following layers to form an entire BAW-SMR were 50 nm sputtered titanium (Ti) as an adhesive layer and 300 nm of sputtered molybdenum (Mo) as the top electrode. Standard lithography was then performed to pattern the uppermost Mo layer. The layout was a so-called single-mask-layout with active resonator top electrode areas of differing size and shapes, with landing pads for probe contacting. Surrounding to these structures, the entire snippet area is filled with the ground area. The method of removal of the remaining areas between top electrodes and the ground aera was dry-etched with xenon-difluoride (XeF₂).

The electrical characterization was undertaken on a wafer prober station with ACP-probes (from Formfactor, pitch configuration: GS 250) and displayed on a Vector Network Analyser (VNA) form Rhode & Schwarz (ZVL). Before any calibration or measurement could be performed, the pre-defined parasitic inductivity and capacitance had to be configured into the VNA device. Calibration included the standard 1-port Sol (SOM)-calibration (SHORT, OPEN, LOAD also called MATCH), whereas the SHORT calibration was performed directly on the large ground aera on the snippet itself to ensure calibration of the probes on the contact material of Mo and the LOAD calibration was performed on a calibration substrate with defined 1-port structures of 50 Ω. OPEN calibration was performed by lifting the probe into air accordingly. The maximum of 4001 data points in the frequency range of 1.5 GHz to 2.5 GHz (resolution 250 Hz) was recorded and a measurement bandwidth of 100 Hz with an incident signal power of 0 dB was given. Obtained is then a standard 1-port Touchstone-file (.s1p) of the S-parameters which can be extracted to see the impedance magnitude as in the curve seen.

Fig. 6 shows a transmission electron microscope image of an inventive layer deposited on a silicon wafer. Although the layer itself has a low density and is possibly porous, a homogenous surface is visible.

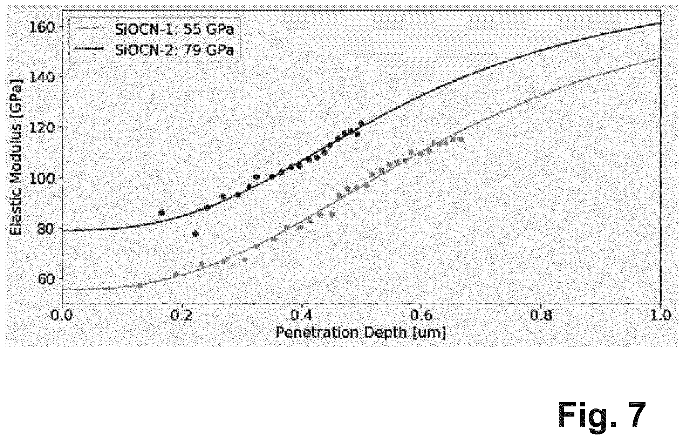

Fig. 7 shows nanoidentation measurements on 1000 nm thick inventive layers, resulting in elastic moduli of 55 GPa and 79 GPa for the two examined layer variants with differing deposition parameters, thus demonstrating a certain tuning range. For the corresponding measurement, thin films of SiOₓC_{y}N_{z} were deposited with a thickness of 1 µm on sippets of 2 cm² sawn from a silicon wafer. The measurement was undertaken on an XP nanoidentation setup with an indenter form Berkovich, which is widely used. The so-called "area function" (gives the load-displacement-curve of the indenter on a defined reference substrate) necessary for calibration was recorded just before sample measurement. Rhe measurement scheme itself included 30 indentation points distributed on a line with a mutual distance of 10 µm on the sample surface. At every point of indentation, the maximum force applied was increased by 1.5 mN, ranging over all points linearly from 1.5 mN up to 45 mN to ensure increasing penetration depths, thereby recording the load-displacement-curves of the indenter into the film. It was aimed to penetrate the thin film in the range between 200 nm and 700 nm in order to obtain the elastic (Young's) modulus of the sample. The recorded load-displacement-curves can be analyzed by the methods of Oliver-Pharr and Fischer-Cripps, fitting a certain curve towards the data points. Extrapolation of the curve thereby states the desired parameter.

## Claims

1. A layer for an acoustic device, in particular for a micro acoustic radio frequency device, wherein the layer has essentially a composition SiOₓC_{y}N_{z}, wherein x, y and z > 0.

2. The layer according to claim 1, wherein the layer is deposited by plasma enhanced chemical vapor deposition.

3. The layer according to claim 1 or 2, wherein the layer is essentially completely amorphous.

4. The layer according to any one of claims 1 to 3, wherein a density of the layer is lower than 1.95 g/cm³, in particular in the range of 1.6 g/cm³ to 1.75 g/cm³.

5. The layer according to any one of claims 1 to 4, wherein the composition of the layer comprises (in wt.-%)
20% to 45%, preferably 25% to 40%, in particular 25% to 35%, silicon
40% to 60%, preferably 45% to 57.5%, in particular 47.5% to 55%, oxygen
3% to 25%, preferably 5% to 20%, in particular 7.5% to 15%, carbon
0.5% to 10%, preferably 1.0% to 7.5%, in particular 3.0% to 5.0% nitrogen.

6. The layer according to any one of claims 1 to 5, wherein the layer has a thickness of less than 1000 nm, preferably 20 nm to 900 nm, in particular 500 nm to 800 nm.

7. The layer according to any one of claims 1 to 6, wherein an acoustic impedance of the layer is 6.0 MRayl to 8.0 MRayl.

8. A stack of alternating layers, the layers being deposited by vapor deposition, in particular chemical vapor deposition, wherein the alternating layers comprise at least one layer according to any one of claims 1 to 7.

9. The stack according to claim 8, wherein the stack comprises a sequence of layers A-B, wherein layers A being layers according of any of claims 1 to 8 and layers B being metallic layers.

10. The stack according to claim 9, wherein the metallic layers are tungsten layers.

11. A Bragg mirror comprising one or more layers according to any one of claims 1 to 8 and/or a stack according to any one of claims 8 to 10.

12. A micro acoustic element comprising a Bragg mirror according to claim 11.

13. A method for depositing a layer consisting essentially of SiOₓC_{y}N_{z}, wherein x, y and z > 0, the layer being designed for a micro acoustic element, the method comprising:
providing a substrate for the deposition of the layer;
depositing the layer by plasma enhanced chemical vapor deposition at a pressure of less than 30 mTorr, wherein at least one precursor molecule is provided for each of silicon, carbon and nitrogen, wherein the substrate is cooled during deposition.

14. The method according to claim 13, wherein the pressure is in the range of 3 mTorr to 25 mTorr, in particular in the range of 6 mTorr to 20 mTorr, and wherein a deposition temperature is below 50°C. in particular below 25°C.

15. The method according to claim 14 or 15, wherein precursor molecules comprise at least one silane component, at least one hydrocarbon component and a nitrogen source.
